(19) Europäisches Patentamt
European Patent Office
Office européen des brevets

(11) Veröffentlichungsnummer: **0 000 890**
**B1**

(12) # EUROPÄISCHE PATENTSCHRIFT

(21) Anmeldenummer: **78100602.8**

(22) Anmeldetag: **07.08.78**

(51) Int. Cl.³: **C 08 G 18/67**, C 08 G 18/32, C 08 G 18/40, // C 09 D 3/72

(54) **Strahlenhärtbare Urethanacrylat-Bindemittel**

(30) Priorität: **19.08.77 DE 2737406**

(43) Veröffentlichungstag der Anmeldung:
**07.03.79 Patentblatt 79/05**

(45) Bekanntmachung des Hinweises auf die Patenterteilung:
**01.10.80 Patentblatt 80/20**

(84) Benannte Vertragsstaaten:
**CH DE FR GB NL**

(56) Entgegenhaltungen:
**DE - A - 2 115 373**
**DE - A - 2 433 908**
**GB - A - 1 495 004**
**US - A - 3 600 359**

(73) Patentinhaber: **BAYER AG**
**Zentralbereich Patente, Marken und Lizenzen**
**D - 5090 Leverkusen 1, Bayerwerk (DE)**

(72) Erfinder: **Schuster, Karl-Ernst, Dr.**
**Heideweg 2**
**D - 4173 Kerken 3 (DE)**
**Rosenkranz, Hans Jürgen, Dr.**
**Heinrich-Kauert-Weg 9**
**D - 4150 Krefeld (DE)**
**Rudolph, Hans, Dr.**
**Haydnstrasse 9**
**D - 4150 Krefeld (DE)**
**Fuhr, Karl, Dr.**
**Kruellsdyk 55**
**D - 4150 Krefeld (DE)**
**Zorn, Bruno, Dr.**
**Semmelweisstrasse 89a**
**D - 5000 Köln 80 (DE)**
**Träubel, Harro, Dr.**
**Dresdener Strasse 14**
**D - 5090 Leverkusen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 000 890 B1

Courier Press, Leamington Spa, England.

## Strahlenhärtbare Urethanacrylat-Bindemittel

Die Erfindung betrifft strahlenhärtbare Bindemittel aus Umsetzungsprodukten von Thio- und/oder Dithiogruppen enthaltenden Polyolen, gegebenenfalls schwefelfreien Polyolen und Hydroxyalkylacrylaten.

Die Umsetzung von präpolymeren Isocyanaten mit Hydroxyalkylacrylaten ist allgemein bekannt und führt zu den sogenannten Urethanacrylaten, die in Abmischung mit den verschiedensten Vinylmonomeren wertvolle Rohstoffe für UV-Licht und elektronenstrahlhärtende Lacke darstellen. Beschrieben sind solche Produkte beispielsweise in der DE—AS 1 644 797, in der britischen Patentschrift 743 514, in der US—PS 3 297 745.

Allgemein kennzeichnend für solche Urethanacrylate ist ihre leichte Darstellbarkeit und die Möglichkeit, durch Variation der verwendeten Komponenten das Eigenschaftsbild in weiten Grenzen zu beeinflussen. Die Erfahrung zeigt jedoch, daß Urethanacrylate wie alle durch Vinylpolymerisation vernetzenden Lackrohstoffe bei ihrem Härtungsvorgang durch Luftsauerstoff stark inhibiert werden. Belichtet manbeispielsweise ein mit einem Photoinitiator versehenes Urethanacrylat durch einen fotografischen Halbtonstufenkeil mit UV-Licht, so läßt sich leicht feststellen, daß die Vernetzungsgeschwindigkeit an der Harzoberfläche um Größenordnungen differiert, je nachdem, ob in Gegenwart von Luftsauerstoff oder in einer inertgasatomosphäre belichtet wird. Im allgemeinen läßt sich sagen, daß nur solche Urethanacrylate in Gegenwart von Luftsauerstoff innerhalb praxisgerechter Zeiten zu härten sind, in denen eine große Häufung von Vernetzungsstellen vorhanden ist. Der Fachmann weiß jedoch daß mit solchen Produkten hergestellte Filme auch in dünnen Schichten außerordentlich hart und spröde sind, so daß sie für eine Lackierung von flexiblen Materialien wie beispielsweise Kunststoff-Folien, Papier oder Textilien ausfallen.

Verringert man jedoch die Vernetzungsdichte solcher Urethanacrylate, um zu elastischen Filmen zu kommen, so ist sehr bald der Punkt erreicht, an dem die Reaktivität des Systems nicht mehr ausreicht, die Luftinhibierung der Filmoberfläche bei der UV-Lichthärtung zu überspielen. Diese Überzüge werden dann selbst nach längerer Belichtungszeit nicht mehr klebfrei. Es hat natürlich nicht an Versuchen gefehlt, diesen entscheidenden Mangel zu beseitigen. So werden, wie z.B. in der DE—AS 2 157 115 und der DE—AS 2 158 529 bzw. in der DE—OS 2 601 408, Urethanacrylate beschrieben, die mit ungesättigten Fettsäuren modifiziert sind. Da solche Rohstoffe, wie allgemein bekannt ist, unter dem Einfluß von Luftsauerstoff Vernetzungsreaktionen eingehen können, sollte ein solcher Vorgang die Sauerstoffinhibierung der Acrylester-Polymerisation kompensieren. Es zeigt sich jedoch in der Praxis, daß der gewünschte Effekt keinesfalls mit der notwendigen Geschwindigkeit eintritt. Auch solche Bindemittel zeigen unmittelbar nach der Härtung zunächst eine klebrige Oberfläche.

Eine weitere Möglichkeit, zu Urethanacrylaten mit geringerer Inhibierung durch Luftsauerstoff zu kommen, besteht darin, synergistisch wirkende Substanzen wie z.B. tertiäre Amine in das Harz mit einzubauen. Solche Produkte zeigen auch bei geringer Vernetzungsdichte eine deutlich gesteigerte Reaktivität. Urethanacrylate dieser Art werden z.B. in der DE—OS 2 140 306 beschrieben. Es gelingt auf diese Weise jedoch nicht, Bindemittel herzustellen, die hochelastisch sind und z.B. über eine Bruchdehnung von $>100\%$ verfügen. Aminmodifizierte Urethanacrylate mit praxisgerechter Aushärtungsgeschwindigkeit erwiesen sich zu hart und spröde für die Beschichtung plastischer Materialien.

Gemäß DE—OS 2 433 908 wird ein Verfahren zur Herstellung strahlungshärtbarer Urethanacrylate u.a. mit Thioäthergruppen beansprucht, wobei diese aus N-Methylolthioäthern des (Meth)Acrylamids, die mindestens noch eine sekundäre Hydroxygruppe tragen, Diisocyanat und Polyhydroxyverbindungen erhalten werden sollen. Ein experimenteller Beleg für solche härtbaren Urethanacrylate mit Thioäthergruppen und ihre Eigenschaften läßt sich aus der genannten Offenlegungsschrift jedoch nicht entnehmen. Eine Nacharbeitung des Beispiels B der DE—OS 2 433 908 mit der Änderung, daß anstelle des Glycerins 1 Mol Thioglycerin ($HS—CH_2—CHOH—CH_2OH$)eingesetzt wurde, ergab ein harzartiges Produkt. Dieses wurde in Beispiel 1 der DE—OS 2 433 908 anstelle von N-(2-Hydroxypropyloxymethyl)-acrylamid eingesetzt. Bereits nach kurzer Zeit wurde ein Gel erhalten, daß nicht mehr mit 1,4-Butandioldiacrylat verdünnbar war.

Da der in der DE—OS 2 433 908 vorgeschlagene Weg. zu Thioäthergruppen enthaltenden photopolymerisierbaren Überzugsmitteln zu gelangen, nicht gangbar ist, konnte u.E. nicht erwartet werden, daß erfindungsgemäß einzusetzende Thio- und/oder Dithiogruppen enthaltende Polyole in den erfindungsgemäßen Urethanacrylaten zu verdünnbaren, nicht gelierten Bindemitteln führen. Da ferner in der DE—OS 2 433 908 keine Aussage über den Einfluß der Thioäthergruppen auf das Überzugsmittel gemacht wird, lag es auch nicht nahe, die Reaktivität von Urethanacrylat-Bindemitteln aus den anspruchsgemässen Komponenten A), B) and C) und die Elastizität der daraus hergestellten Filme durch Einbau von Thio- und/oder Dithioäthergruppen zu verbessern.

Aus der DE—OS 2 115 373 ist es weiterhin bekannt, lichtempfindliche Zusammensetzungen aus einem Polyurethan-Vorpolymerisat, einem Photosensibilisator und gegebenenfalls äthylenisch ungesättigten Monomeren herzustellen. Das Polyurethan-Vorpolymerisat wird aus einer Hydroxylkomponente, die mindestens 5 Ätherbindungen und eine äthylenisch ungesättigte Doppelbindung an den Endgruppen aufweist, mit einem Polyisocyanat erhalten. Durch die Vielzahl der Ätherbindungen

von mindestens 5 soll u.a. eine Steigerung der Elastizität im Endprodukt erreicht werden. Ausgehend von dieser Lehre war es nicht zu erwarten, daß bei den erfindungsgemäßen Zusammensetzungen bereits der Einbau einer Hydroxylkomponente mit nur einer Thioäthergruppe nicht nur eine unerwartete Verbesserung der Elastizität des Endproduktes, sondern gleichzeitig eine überraschende Steigerung der Reaktivität bewirken würde, wie die nachstehenden Beispiele und Vergleichsversuche belegen.

Es war deshalb sehr überraschend und nicht zu erwarten, daß der Einbau von Schwefel in Form von Thio- und/oder Dithiogruppen in Urethanacrylate zu Bindemitteln führt, die nicht nur, reaktiver, sondern vor allem nach der Strahlenhärtung sehr viel elastischer als vergleichbare schwefelfreie Bindemittel sind. Dabei ist es unerheblich, wie der Schwefel in das Harz eingebaut wird, ob in Form von Thio- (—S) oder Dithiogruppen (—S—S—); aber nur in dieser Form, d.h. in der formalen Oxydationsstufe -1 bzw. -2 ist er hinsichtlich der Elastizität sehr wirksam. Ein reines Zumischen von Thioäthern zu diesen Bindemitteln hat zwar eine reaktivitätssteigernde Wirkung, jedoch keinen Einfluß auf die Elastizität.

Gegenstand der Erfindung ist somit ein strahlenhärtbares Bindemittel, bestehend aus einem Umsetzungsprodukt aus

A) 1 Grammäquivalent NCO eines Polyisocyanats mit 2 bis 3, insbesondere 2, Isocyanatgruppen pro Molekül);

B) 0 bis 0,7 Grammäquivalenten OH eines Polyols mit mindestens 2, insbesondere 2 bis 6, OH-Gruppen pro Molekül, frei von organisch gebundenem Schwefel, mit OH-Zahlen von 50 bis 1830 mg KOH/g Substanz;

C) 0,01 bis 0,7 Grammäquivalenten OH eines Hydroxyalkylacrylats mit 2 bis 6, insbesondere 2 bis 4, C-Atomen in der Alkylgruppe,

gegebenenfalls in Mischung mit anderen copolymerisierbaren Monomeren, dadurch gekennzeichnet, daß das Umsetzungsprodukt zusätzlich.

D) 0,01 bis 0,3 Grammäquivalente OH eines Thio- oder Di thio- bzw. Thio- und Dithiogruppen enthaltenden Polyols mit mindestens 2, insbesondere 2 bis 4, OH-Gruppen pro Molekül mit OH-Zahlen von 50 bis 920 mg KOH/g Substanz

eingebaut enthält, die Summe der OH-Grammäquivalente B bis D 1 bis 1,2 ist und der Gehalt an organisch gebundenem Schwefel, herrührend aus den Thio- und Dithiogruppen, 0,01 bis 10 Gew.-%, insbesondere 0,1 bis 5 Gew.-%, bezogen auf Bindemittel, beträgt.

Gegenstand der Anmeldung sind weiterhin die Abmischungen der schwefelmodifizierten Urethanacrylate mit mono- und/oder polyfunktionellen Vinylmonomeren als strahlenhärtende Bindemittel.

Unter dem Begriff Polyisocyanate werden di- und höherfunktionelle Isocyanate verstanden, vorzugsweise di- und trifunktionelle, insbesondere difunktionelle. Beispielhaft seien genannt: Toluylendiisocyanate, Diphenylmethandiisocyanate, Isophorondiisocyanat, Xylylendiisocyanat, Hexamethylendiisocyanat.

Die Polyisocyanate können mit di- und höherfunktionellen Polyolen oder Di- und Polyaminen mit mindestens zwei primären Aminogruppen zu präpolymeren Isocyanaten umgesetzt werden, wobei die Polyolkomponente auch ein Polyäther- und/oder Polyesterpolyol sein kann (vgl. britische Patentschrift 743 514 und US—PS 2 969 386).

Unter einem Grammäquivalent NCO wird die Menge einer Verbindung in Gramm verstanden, in der eine Isocyanatgruppe enthalten ist. Entsprechend ist ein Grammäquivalent OH die Menge einer Verbindung in Gramm, in der eine Hydroxylgruppe enthalten ist.

Unter Komponente B werden vorzugsweise aliphatische, gesättigte, 2—6 wertige, insbesondere 2—4 wertige, Polyole mit OH-Zahlen von 50—1830, vorzugsweise 100—1060 mg KOH/g Substanz verstanden oder die vorgenannten Polyole, deren aliphatische Ketten eine oder mehrere, gleiche oder verschiedene Gruppen der Reihe Phenylen, Cyclohexylen, Oxy(—O—), Carboxylato

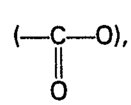

Ureylen

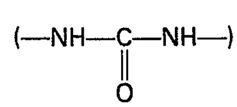

und Oxycarbonylamino

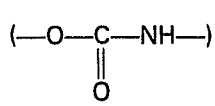

enthalten oder Mischungen der Polyole. Die Komponente B ist frei von organisch gebundenem Schwefel.

Ganz besonders werden als Komponente B oxäthylierte aliphatische, gesättigte Di- und/oder Triole mit OH-Zahlen von 100 bis 1060 mg KOH/pro Gramm Substanz bevorzugt.

Beispiele für Komponente B sind:

1. Aliphatische gesättigte, 2—6 wertige Alkohole, insbesondere 2—4 wertige Alkohole wie z.B. Äthylenglykol, Propandiol-1,2 Propandiol-1,3, Neopentylglykol, Butandiol-1,4, Hexandiol-1,6, Dekandiol-1,10, Glycerin, Trimethylolpropan, Pentaerythrit, Dipentaerythrit sowie die Oxalkylierungsprodukte der 2—6 wertigen Alkohole mit 1,2-Alkylenoxiden wie Äthylenoxid oder Propylenoxid; cycloaliphatische Diole wie Cyclohexandiol-1,4 und 4,4'-Dihydroxy-cyclohexyl-2,2-alkane, wie 4,4'-Dihydroxy-cyclohexyl-2,2-propan und araliphatische 2-wertige Alkohole, die gegebenenfalls 1—2 Äthersauerstoffatome enthalten wie bis(oxäthyliertes Bisphenol A sowie bis(oxpropyliertes) Bisphenol A.

2. Gesättigte oder ungesättigte, vorzugsweise gesättigte Polyester mit mindestens zwei freien Hydroxylgruppen aus den unter 1. genannten Alkoholen und mindestens einer Polycarbonsäure oder deren Anhydriden, insbesondere Dicarbonsäuren wie Maleinsäure, Fumarsäure, Mesaconsäure, Citraconsäure, Itaconsäure, Bernsteinsäure, Glutarsäure, Adipinsäure, Sebacinsäure, Phthalsäure, Isophthalsäure, Terephthalsäure, Trimellitsäure, Hexahydrophthalsäure Tetrahydrophthalsäure, Endomethylentetrahydrophthalsäure, Methylhexahydrophthalsäuren.

3. Mischungen 1. und 2.

4. Ureylen- und/oder Oxycarboxylamino (=Urethan)-gruppen enthaltende Polyole, erhalten aus den unter 1. und 2. genannten Polyolen und den unter A) und in der Anmeldung im einzelnen genannten Polyisocyanaten.

Als Hydroxyalkylacrylate C) kommen beispielsweise 2-Hydroxyäthyl-, 2-Hydroxypropyl-, 2-Hydroxybutyl-, 3-Hydroxypropyl-, 4-Hydroxybutyl- und 6-Hydroxyhexylacrylat in Frage. Bevorzugt werden 2-Hydroxyäthylacrylat, 2-Hydroxypropylacrylat und 4-Hydroxybutylacrylat.

Unter Komponente D) werden vorzugsweise aliphatische, gesättigte 2—4 wertige, insbesondere 2-wertige, Polyole mit OH-Zahlen von 50 bis 920 und mit mindestens einer Thio- und/oder mindestens einer Dithio-, vorzugsweise mindestens einer Thiogruppe in der aliphatischen Kette, die zusätzlich eine oder mehrere, gleiche oder verschiedene Gruppen der Reihe Phenylen, Cyclohexylen, Oxy, Carboxylato, Ureylen und Oxycarbonylamino enthalten kann oder Mischungen der Polyole verstanden.

Ganz besonders bevorzugt sind als Komponente D) gesättigte aliphatische Glykole, die eine oder mehrere Thiogruppen in der aliphatischen Kette enthalten, gesättigte aliphatische Glykole, die eine oder mehrere Thiogruppen und ein oder mehrere Oxy- und ein oder mehrere Carboxylatogruppen in der aliphatischen Kette enthalten, gesättigte aliphatische Glykole, die ein oder mehrere Thiogruppen und ein oder mehrere Oxygruppen (—O—) in den aliphatischen Ketten enthalten, sowie Glykole, erhalten durch Umsetzung eines Mol eines Diglycidyläthers eines Glykols oder Diphenols bzw. eines Diglycidylesters einer Dicarbonsäure mit 2 Molen eines Mercaptans, alle besonders bevorzugten Glykole sollen OH-Zahlen von etwa 200 bis 920 besitzen.

Als Komponenten D) mit mindestens zwei aliphatischen Hydroxylgruppen und mindestens einer Thio- oder Dithiogruppe und mit OH-Zahlen von 50 bis 920 seien im einzelnen beispielhaft genannt:

1. Oxalkylierungsprodukte mit zwei aliphatischen Hydroxylgruppen aus Schwefelwasserstoff oder Thiodiglykolen und 1,2-Alkylenoxiden bzw. 1,2-Cycloalkylenoxiden wie Äthylenoxid, 1,2-Propylenoxid, 1,2-Butylenoxid, Cyclohexylenoxid oder deren Mischungen Styroloxid, insbesondere Äthylenoxid. Für Äthylenoxid beispielhaft angegeben, entsprechen diese Oxalkylierungsprodukte der allgemeinen Formel

$$H[OCH_2{-\!\!-}CH_2]_xS[CH_2{-\!\!-}CH_2O]_yH$$

in der

x bzw. y ganze Zahlen > 0 bedeuten, so daß OH-Zahlen von 50 bis 920 resultieren.

2. Kondensationsprodukte aus gemäß D1) erhaltenen Oxalkylierungsprodukte, beispielsweise Thiodiglykol, mit sich selbst oder untereinander und gegebenenfalls in Gegenwart schwefelfreier zwei- und mehrwertiger Alkohole. Die Kondensationsprodukte besitzen OH-Zahlen von 50 bis < 920.

3. Oxalkylierungsprodukte aus Alkylenoxiden, wie unter D1) angegeben, und Dimercaptoalkanen wie Dimercaptoäthan, Dimercaptobutan oder Dimercaptodialkylsulfiden wie Dimercaptodiäthylsulfid.

4. Dihydroxydialkylsulfide mit mehr als 2 C-Atomen in der Alkylgruppe wie 4,4'-Dihydroxydibutylsulfid und deren Oxalkylierungsprodukte mit Alkylenoxiden, wie unter D1) angegeben.

5. Oxalkylierungsprodukte aus Alkylenoxiden, wie unter D1) angegeben, und 3- und höherwertigen Mercaptoalkanolen (die Funktionalität bezieht sich auf Summe aus HS- und HO-), wie Thioglycerin und Dithioglycerin.

6. Oxalkylierungsprodukte aus Alkylenoxiden, wie unter D1) angegeben, und Thiodiglykolsäure, Dithiodiglykolsäure; Alkylen-bis(thioglykolsäuren) wie Methylen-bis(thioglykolsäure), Äthylen-bis(thioglykolsäure), Tetramethylen-bis(thioglykolsäure); Dialkyldisulfid-dicarbonsäuren wie Diäthyldisulfid-2,2'-dicarbonsäure.

7. Oxalkylierungsprodukte aus Alkylenoxiden, wie unter D1) angegeben, und Mercaptomonocarbonsäuren wie Thioglykolsäure, Thiomilchsäure, Mercaptobuttersäuren, Mercaptododecansäure, wobei die Carboxylgruppe und die Mercaptogruppe (—SH) oxalkyliert sind.

8. Kondensationsprodukte (Polyester aus den unter D6) genannten, Thio- und/oder Dithiogruppen enthaltenden Dicarbonsäuren und aliphatischen, gesättigten 2—6 wertigen vorzugsweise 2-wertigen Alkoholen, wie unter B1) beschrieben und/oder mindestens einem der unter D1) bis D5) genannten Thio- oder Dithiogruppen enthaltenden Di- und Polyol.

9. Anlagerungsprodukte von di- und höherfunktionellen 1,2-Epoxidverbindungen, z.B. Diglycidyläther des Bisphenol A oder Hexahydrophthalsäurediglycidylester und Schwefelwasserstoff im Sinne der Gleichung.

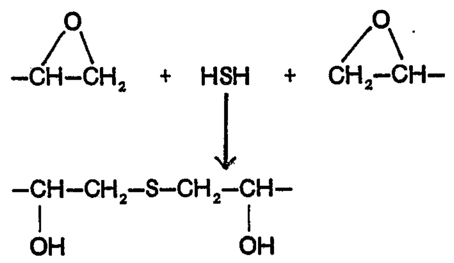

oder mit Mercaptoalkanolen im Sinne der Gleichung

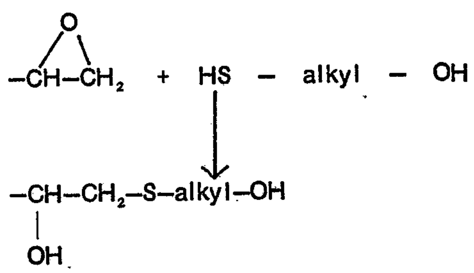

oder mit Thio- und/oder Dithiogruppen enthaltenden Dicarbonsäuren, wie unter D6) angegeben, im Sinne der Gleichung

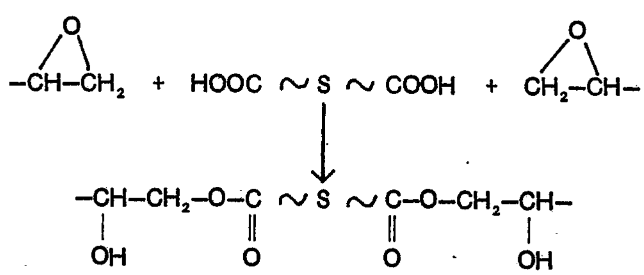

oder mit Dimercaptoalkanen oder Dimercaptodialkylsulfiden.

Die schwefelhaltigen Polyole können in Abmischung mit üblichen Polyolen, Polyätherpolyolen, Polyesterpolyolen bei Temperaturen von 20° bis 150°C mit Polyisocyanaten zu präpolymeren schwefelhaltigen Polyisocyanaten umgesetzt werden.

In einer anschließenden Reaktion können diese schwefelhaltigen präpolymeren Isocyanate mit Hydroxyalkylacrylaten bei Temperaturen von 20 bis 90°C umgesetzt werden, wobei die Reaktionen sowohl im Eintopfverfahren als auch in mehreren Stufen durchgeführt werden können.

Die Umsetzung der Polyisocyanate mit den Polyolen kann in an sich bekannter Weise z.B. mit Zinnoctoat, Dibutylzinndilaurat oder tertiären Aminen katalysiert werden. Ebenso kann das Urethanacrylat durch Zugabe geeigneter Inhibitoren und Antioxydantien je 0,001-0,1 Gew.-%, bezogen auf Gesamtmischung vor vorzeitiger und unerwünschter Polymerisation geschützt werden. Diese Polymerisationsinhibitoren werden auch zur Erzielung einer hohen Dunkellagerstabilität zweckmäßigerweise eingesetzt.

Geeignete Hilfsmittel dieser Art sind beispielsweise Phenole und Phenolderivate, vorzugsweise sterisch gehinderte Phenole, die in beiden o-Stellungen zur phenolischen Hydroxygruppe Alkylsubstituenten mit 1—6 C-Atomen enthalten, Amine, vorzugsweise sekundäre Acrylamine und ihre Derivate, Chinone, Kupfer-I-Salze organischer Säuren oder Anlagerungsverbindungen von Kuper(I)halogeniden an Phosphite.

Namentlich seien genannt: 4,4'-Bis-(2,6-di-tert.-butyl-phenol), 1.3.5-Trimethyl-2.4.6-tris-(3.5-di-tert.-butyl-4-hydroxy-benzyl)-benzol, 4.4'-Butyliden-bis-(6-tert.-butyl-m-kresol), 3.5-Di-tert.-butyl-4-hydroxybenzyl-phosphonsäurediäthylester, N,N'-Bis-(ß-naphtyl)-p-phenylendiamin, N,N'-Bis-(1-methylheptyl)-p-phenylendiamin, Phenyl-ß-naphtylamin, 4,4'-Bis-($\alpha$,$\alpha$-dimethylbenzyl)-diphenylamin, 1.3.5-Tris-(3.5-di-tert.-butyl-4-hydroxy-hydrocinnamoyl)-hexahydro-s-triazin, Hydrochinon, p-Benzochinon, 2.5-Di-tert.-butylchinon, Toluhydrochinon, p-tert.-Butylbenzcatechin, 3-Methylbrenzcatechin, 4-Äthylbrenzcatechin, Chloranil, Naphthochinon, Kupfernaphthenat, Kupferoctoat, Cu(I)Cl/Triphenylphosphit, Cu(I)Cl/Trimethylphosphit, Cu(I)Cl/Trischloräthyl-phosphit, Cu(I)Cl/Tripropylphosphit, p-Nitrosodimethylanilin.

Weitere geeignete Stabilisatoren sind in "Methoden der organischen Chemie" (Houben-Weyl), 4. Auflage, Band XIV/1, S. 433-452, 756, Georg Thieme Verlag, Stuttgart, 1961, beschrieben. Sehr gut geeignet ist z.B. p-Benzochinon und/oder Hydrochinonmonomethyläther in einer Konzentration von 0.001 bis 0,05 Gew.-%, bezogen auf Gesamtmischung.

Die erfindungsgemäßen Umsetzungsprodukte können teilweise ohne Zusatz copolymerisierbarer Monomerer oder Lösungsmittel zur Anwendung gelangen. Da es sich jedoch in vielen Fällen um viskose Produkte handelt, empfiehlt es sich, sie mit copolymerisierbaren Monomeren abzumischen, um verarbeitungsgerechte Viskositäten zu erhalten und/oder die Eigenschaften der Härtungsprodukte zu variieren.

Geeignete Monomere sind:

1) Ester der Acryl- oder Methacrylsäure mit aliphatischen $C_1$—$C_8$, cycloaliphatischen $C_5$—$C_6$, araliphatischen $C_7$—$C_8$ Monoalkoholen, beispielsweise Methylacrylat, Äthylacrylat, n-Propylacrylat, n-Butylacrylat, Methylhexylacrylat, 2-Äthylhexylacrylat und die entsprechenden Methacrylsäureester; Cyclopentylacrylat, Cyclohexylacrylat oder die entsprechenden Methacrylsäureester; Benzylacrylat, $\beta$-Phenyläthylacrylat und entsprechende Methacrylsäureester;

2) Hydroxyalkylester der Acryl- oder Methacrylsaüre mit 2—4 C-Atomen in der Alkoholkomponente, wie 2-Hydroxyäthylacrylat, 2-Hydroxypropylacrylat, 3-Hydroxypropylacrylat, 2-Hydroxybutylacrylat, 4-Hydroxybutylacrylat oder entsprechende Methacrylsäureester;

3) Di- und Polyacrylate sowie Di- und Polymethacrylate von Glykolen mit 2 bis 6 C-Atomen und Polyolen mit 3—4 Hydroxylgruppen und 3 bis 6 C-Atomen, wie Äthylenglykoldiacrylat, Propandiol-1,3-diacrylat, Butandiol-1,4-diacrylat, Hexandiol-1,6-diacrylat, Trimethylolpropantriacrylat, Pentaerythrittri- und -tetraacrylat sowie entsprechende Methacrylate, ferner Di(meth)acrylate von Polyätherglykolen des Glykols, Propandiol-1,3, Butandiol-1,4;

4) Aromatische Vinyl und Divinylverbindungen, wie Styrol, Methylstyrol, Divinylbenzol;

5) N-Methylolacrylamid oder N-Methylolmethacrylamid sowie entsprechende N-Methylolalkyläther mit 1—4 C-Atomen in der Alkyläthergruppe bzw. entsprechende N-Methylolallyläther, insbesondere N-Methoxymethyl(meth)acrylamid, N-Butoxymethyl(meth)acrylamid und N-Allyloxymethyl(meth)-acrylamid;

6) Vinylalkyläther mit 1—4 C-Atomen in der Alkylgruppe, wie Vinylmethyläther, Vinyläthyläther, Vinylpropyläther, Vinylbutyläther;

7) Trimethylolpropanidallyäthermono(meth)acrylat, Vinylpyridin, N-Vinylcarbazol, Triallylphosphat, Triallylisocyanurat und andere.

Es können auch Gemische aus einem oder mehreren der vorgenannten Monomeren eingesetzt werden. Die Zusätze betragen etwa 5—50 Gew.-%, vorzugsweise 20—40 Gew.-%, bezogen auf Mischung aus erfindungsgemäßen Reaktionsprodukten und zusätzlichen Monomeren.

Ebenso ist es möglich, eine geeignete Viskosität durch Abmischen mit inerten Lösungsmitteln wie Butylacetat, Äthylacetat, Äthanol, Isopropanol, Butanol, Aceton, Äthylmethylketon, Diäthylketon, Cyclohexan, Cyclohexanon, Cyclopentan, Cyclopentanon, n-Heptan, n-Hexan, n-Octan, Isooctan, Toluol, Xylol, Methylenchlorid, Chloroform, 1,1-Dichloräthan, 1,2-Dichloräthan, 1,1,2-Trichloräthan, Tetrachlorkohlenstoff einzustellen, Um eine solche verarbeitungsgerechte Viskosität zu erhalten, können 5 bis 50 Gew.-%, vorzugsweise 20 bis 40 Gew.-% an Lösungsmitteln, bezogen auf Mischung aus erfindungsgemäßen Reaktionsprodukte und Lösungsmittel, zugesetzt werden.

Natürlich ist es auch möglich, Mischungen aus zusätzlichen Monomeren und Lösungsmitteln innerhalb der angegebenen Mengenverhältnisse einzusetzen.

Die Härtung der erfindungsgemäßen Reaktionsprodukte, gegebenenfalls in Mischung mit anderen copolymerisierbaren Monomeren erfolgt mittels energiereicher Strahlung, wie UV-Licht, Elektronen- oder Gammastrahlen.

Vorzugsweise werden die erfindungsgemäßen Reaktionsprodukte als durch UV-Licht härtbare Überzugsmassen eingesetzt, wobei ihr besonderer Vorteil darin liegt, daß sie auch in Gegenwart von Luftsauerstoff in sehr kurzen Zeiten aushärten. Für diese Anwendung ist der Zusatz von Photoinitiatoren erforderlich.

Als Photoinitiatoren sind die üblicherweise eingesetzen Verbindungen geeignet, beispielsweise Benzophenon sowie ganz allgemein aromatische Ketoverbindungen, die sich vom Benzophenon ableiten, wie Alkylbenzophenone, halogenmethylierte Benzophenone, gemäß der deutschen Offenlegungsschrift 1 949 010, Michlers Keton, Anthron, halogenierte Benzophenone. Ferner eignen sich Benzoin und seine Derivate, etwa gemäß den deutschen Offenlegungsschriften 1 769 168, 1 769 853,

1 769 854, 1 807 297, 1 807 301, 1 916 678, 2 430 081 und der deutschen Auslegeschrift 1 694 149. Ebenfalls wirksame Photoinitiatoren stellen Anthrachinon und zahlreiche seiner Derivate dar, beispielsweise β-Methylanthrachinon, tert. Butylanthrachinon und Anthrachinoncarbonsäureester, ebenso Oximester gemäß der deutschen Offenlegungsschrift 1 795 089.

Werden die erfindungsgemäßen Reaktionsprodukte ohne Zusatz weiterer Monomerer gehärtet, so werden als Photoinitiatoren bevorzugt die Oximester der deutschen Offenlegungsschrift 1 795 089 sowie Benzophenonderivate der deutschen Offenlegungsschrift 1 949 010 eingesetzt.

Die erwähnten Photoinitiatoren, die je nach Verwendungszweck der erfindungsgemäßen Massen in Mengen zwischen 0,1 und 20 Gew.-%, vorzugsweise 0,1—5 Gew.-%, bezogen auf polymerisierbare Komponenten eingesetzt werden, können als einzelne Substanz oder, wegen häufiger vorteilhafter synergistischer Effekte, auch in Kombination miteinander verwendet werden.

Häufig kann es vorteilhaft sein, sei es zur Verbesserung der filmbildenden Eigenschaften der Harzmassen oder aber um eine besonders kratzfeste Oberfläche der Schichten zu erhalten, weitere Zusätze zu verwenden. So ist ein Abmischen mit anderen Harztypen, beispielsweise mit gesättigten oder ungesättigten Polyestern durchaus möglich.

Vorzugsweise werden die Harze in Mengen von 1—50 Gew.-%, bezogen auf die polymerisierbaren Komponenten eingesetzt. Grundsätzlich jedoch sollten nur solche Harze mitverwendet und ihre Menge soweit begrenzt werden, daß eine Beeinträchtigung der Reaktivität nicht auftritt. Geeignete in de Lackindustrie gebräuchliche Lackharze sind in den Lackrohstofftabellen von E. Karsten, 5. Auflage, Curt R. Vincentz Verlag, Hannover, 1972, Seiten 74—106, 195—258, 267—293, 335—347, 357—366 beschrieben.

Vorteilhafte Zusätze, die zu einer weiteren Steigerung der Reaktivität führen können, sind bestimmte tert. Amine wie z.B. Triäthylamin und Triäthanolamin.

Die genannten Stoffe werden vorzugsweise in Mengen von 0 bis 5 Gew.-% bezogen auf die polymerisierbaren Komponenten, eingesetzt.

Ein typisches erfindungsgemäßes Harz wird z.B. hergestellt durch Umsetzung eines Diisocyanats (z.B. Toluylendiisocyanat mit Thiodiglykol, Hydroxyäthylacrylat und z.B. einem trifunktionellen Polyäther auf Basis von äthoxyliertem Trimethylolpropan bei 60°C unter Überleiten von Luft in Gegenwart von 0,01 Gew.-Tin. Zinnoctoat als Katalysator und 0,01 Gew.-Tln. p-Benzochinon als stabilisator. Nach Beendigung der Reaktion soll der NCO-Gehalt des Harzes <0,1% sein und der elementaranalytisch bestimmte Schwefelgehalt kann dann zwischen 0,7 und 1% liegen. Ein solches Harz kann mit Mono-, di- und/oder trifunktionellen Acrylsäureestern abgemischt werden und ergibt, versehen mit einem Photoinitiator eine UV härtende Beschichtung für Leder, Kunstleder oder Kunststoff, die nach der Photopolymerisation den Ansprüchen hinsichtlich Knickechtheit bzw. Reibechtheit genügt.

Als Strahlenquellen zur Durchführung der Photopolymerisation können künstliche Strahler, deren Emission im Bereich von 2500—5000 Å vorzugsweise 3000—4000 Å liegt, verwendet werden. Vorteilhaft sind Quecksilberdampf-, Xenon- und Wolfram-Lampen, insbesondere Quecksilberhochdruckstrahler.

In der Regel lassen sich Schichten der erfindungsgemäßen Reaktionsprodukte mit einer Dicke zwischen 1 μm und 0,1 mm (1 μm = $10^{-3}$mm) in weniger als einer Sekunde zu einem Film aushärten, wenn sie mit dem Licht einer ca. 8 cm entfernten Quecksilberhochdrucklampe, beispielsweise vom Typ HTQ-7 der Firma Philips, bestrahlt werden.

Werden Füllstoffe bei der Verwendung der erfindungsgemäßen Harzmassen als UV-Lichthärtende Überzüge mitverwendet, so ist deren Einsatz auf solche beschränkt, die durch ihr Absorptionsverhalten den Polymerisationsvorgang nicht unterdrücken. Beispielsweise können Talkum, Schwerspat, Kreide, Gips, Kieselsäuren, Asbestmehle und Leichtspat als lichtdurchlässige Füllstoffe verwendet werden.

Prinzipiell sind alle Füllstoffe, Pigmente und Verstärkungsmaterialien, wie sie in der Lackchemie üblicherweise eingesetzt werden, verwendbar.

Das Auftragen der Überzugsmittel auf geeignete Substrate kann mittels in der Lackindustrie üblichen Methoden, wie Sprühen, Walzen, Rakeln, Drucken, Tauchen, Fluten, Streichen, Pinseln, erfolgen.

Geeignete Substrate sind Papier, Kartonagen, Leder, Holz, Kunststoffe, Textilien, keramische Materialien, Metalle, vorzugsweise Kunststoff und Leder. Da die Überzugsmittel in Sekundenbruchteilen bis zu wenigen Sekunden zu Filmen mit ausgezeichneten mechanischen Eigenschaften aushärten, ist es beispielsweise möglich, einen Beschichtungsvorgang den in der Druckbranche üblichen Verarbeitungsgeschwindigkeiten anzupassen.

Die erfindungsgemäßen Bindemittel sind auch zur Herstellung von Photoreliefdruckplatten bzw. Photoresistmaterialien hervorragend geeignet.

Der verwendete Philips-HTQ-7-Strahler ist eine Quecksilberhochdrucklampe der Firma Philips.

In den folgenden Beispielen seien zur Verdeutlichung der Erfindung einige typische Ausführungsformen dargelegt. Die in den Beispielen angegebenen Teile und Prozentgehalte beziehen sich auf das Gewicht, sofern nicht anders vermerkt.

## Beispiel 1

Es wird ein urethangruppenhaltiges erfindungsgemäßes Acrylat hergestellt durch Umsetzung von

111 g Isophorondiisocyanat (0,5 Mol), mit 46,4 g Hydroxyäthylacrylat (0,4 Mol), 6,1 g Thiodiglykol (0,05 Mol) und 134 g eines oxäthylierten Trimethylolpropans mit einer OH-Zahl 250 (Molgewicht 675).

Nach Vorlegen der gesamten Isocyanatmenge wird unter Kühlen und Rühren bei 40—50°C innerhalb von 2 Stunden das Thiodiglykol zugetropft, wobei die Reaktionstemperatur von 60°C nicht überschritten werden sollte. Anschließend wird unter Überleiten von Luft nach Zugabe von 0,1 g Zinnoctoat und 0,15 g Benzochinon bei 50—60°C unter Kühlen das Hydroxyäthylacrylat in der Weise eingetropft, daß die Temperatur 65°C nicht überschreitet. Nach Erreichen des NCO-Wertes von ca. 14% (ca. 4 h) wird das oxäthylierte Trimethylolpropan portionsweise zugegeben.

Es wird unter überleiten trockner Luft so lange bei 60°C gerührt, bis der NCO-Wert 0,1 Gew.-% beträgt. Es entsteht ein farb- und geruchloses mittelviskoses Harz.

Vergleich 1

Es wird wie unter Beispiel 1 verfahren jedoch mit der Änderung, daß statt 6,1 g Thiodiglykol 5,3 g Diäthylenglykol eingesetzt werden. Es resultiert ebenfalls ein farb- und geruchloses Harz, frei von chemisch gebundenem Schwefel, mit einem NCO-Gehalt von < 0,1 Gew.-%.

Vergleich 2

Es wird wie unter Beispiel 1 verfahren, jedoch mit der Änderung, daß statt 6,1 g Thiodiglykol 6,5 g N-Methyldiäthanolamin eingesetzt werden. Dieses Harz, frei von chemisch gebundenem Schwefel, ist äußerlich von den Harzen nach Beispiel 1 und Vergleich 1 nicht zu unterscheiden.

Anwendung

Es werden jeweils 50 Teile der Harze nach Beispiel 1 und den Vergleichen 1 und 2 mit 10 Teilen Äthylacetat und mit 1,5 Teilen $\alpha$-Cyanoäthyl-benzoinäthyläther (Photoinitiator) versetzt und mit einem Rakel zu einem 200 $\mu$m dicken Film auf einer Glasplatte ausgezogen. Nach dem Ablüften werden die Filme auf einem Transportband mit regelbarer Bandgeschwindigkeit unter einem Philips HTO 7-Brenner zu klebfreien Überzügen ausgehärtet. Die so ausgehärteten Filme wurden dann vorsichtig von der Glasplatte gelöst und ihre Bruchdehnung nach DIN 53 455 geprüft. Ergebnisse siehe Tabelle 1.

TABELLE 1

| | Reaktivität (Bandgeschwindigkeit m /Min.) | Bruchdehnung |
|---|---|---|
| Harz nach Beispiel 1 | 25 | 125 |
| Harz nach Vergleich 1 | 10 | 80 |
| Harz nach Vergleich 2 | 25 | 80 |

Aus der Tabelle ist zu erkennen, daß das erfindungsgemäße Harz nach Beispiel 1 deutlich reaktiver als ein unmodifiziertes und wesentlich elastischer als ein nicht schwefel- bzw. ein stickstoffmodifiziertes Urethanacrylat ist.

Beispiel 2

Es wird ein präpolymeres Urethanacrylat gemäß Beispiel 1 hergestellt, jedoch mit der Änderung, daß statt 6,1 g Thiodiglykol 22,4 g eines Polyesters aus Triäthylenglykol und Methylenbisthioglykolsäure (OH-Zahl: 250) eingesetzt werden.

Vergleich 3

Es wird ein Harz analog Beispiel 1 hergestellt jedoch mit der Änderung, daß statt 6,1 g Thiodiglykol 20 g eines Polyesters aus Adipinsäure und Triäthylenglykol (OH-Zahl: 280) eingesetzt werden.

Anwendung

Es erfolgt die gleiche Anwendung wie zum Beispiel 1. Ergebnisse siehe Tabelle 2.

TABELLE 2

| | Reaktivität (Bandgeschwindigk. m/Min.) | Bruchdehnung % |
|---|---|---|
| Harz nach Beispiel 2 | 30 | 90 |
| Harz nach Vergleich 3 | 10 | 40 |

Wie ersichtlich wirkt sich auch hier der Einbau von organisch gebundenem Schwefel positiv auf die Reaktivität und Elastizität aus.

### Beispiel 3

35 g eines Bisepoxids auf Basis von Hexahydrophthalsäurebisglycidylester (Epoxyäquivelentgewicht: 175) werden mit 40 g Undecancarbonsäure bei 90°C bis zur Säurezahl 0 umgesetzt. Das Um- Nach 24 Stunden ist die Reaktion beendet und kein freies SH mehr nachweisbar. Das Umsetzungsprodukt wird anschließend mit 34,8 g Toluylendiisocyanat und dann mit 23 g Hydroxyäthylacrylat umgesetzt. Es resultiert ein Harz mit einem NCO-Gehalt < 0,1 Gew.-%.

### Vergleich 4

35 g eines Bisepoxids auf Basis von Hexahydrophthalsäurebisglycidylester (Epoxyäquivalentgewicht: 175) werden mit 40 g Undecancarbonsäure bei 90°C bis zur Säurezahl 0 umgesetzt. Das Umsetzungsprodukt wird anschließend bei t = 60°C mit 34,8 g Toluylendiisocyanat und dann mit 23,0 g Hydroxyäthylacrylat umgesetzt. Es resultiert ein Harz mit einem NCO-Gehalt 0,1 Gew.-%. Im Vergleich 4 wurde anstelle des $C_{12}$-Mercaptans in Beispiel 3 eine aliphatische, gesättigte $C_{12}$-Carbonsäure eingesetzt, da der entsprechende $C_{12}$-Alkohol (Laurylalkohol) unvollständig reagierte.

### Anwendung

Es erfolgt die gleiche Anwendung wie zu den Beispielen 1 und 2. Ergebnisse siehe Tabelle 3.

TABELLE 3

| | Reaktivität (Bandgeschwindigkeit m/Min.) | Bruchdehnung % |
|---|---|---|
| Harz nach Beispiel 3 | 5 | 130 |
| Harz nach Vergleich 4 | - x) | - x) |

x) Film war trotz extrem langer Belichtungszeit noch stark klebrig.

Bei dieser Anwendung tritt der Vorteil der Schwefelmodifizierung deutlich hervor.

### Beispiel 4

417 g Toluylendiisocyanat werden mit 36 g Thiodiglykol, 220 g Hydroxyäthylacrylat, 670 g eines äthoxylierten Trimethylolpropans (OH-Zahl 250) in Gegenwart von 0,15 g Zinnoctoat 8 Stunden bei 60°C umgesetzt, bis der NCO-Wert <0,1% beträgt. 500 g dieses Harzes werden mit 175 g eines Triacrylats von äthoxyliertem Trimethylolpropan mit einer OH-Zahl von 550, 270 g Hydroxyäthylacrylat 50 g Benzophenon, 45 g Triäthanolamin sowie mit 20 g eines handelsüblichen Alkydharzes aus Benzoesäure, 2-Äthylhexansäure, Phthalsäure, gesättigte, verzweigte synthetische $C_{18}$-Carbonsäure, Trimethylolpropan und Glycerin vermischt. Es resultiert ein farbloses Bindemittel mit einer Viskosität von 10 Poise bei t = 20°C.

Anwendung A

Ein gerauhtes Baumwollgewebe wurde in üblicher Weise nach dem Umkehrverfahren über Trennpapier mit einer schwarz eingefärbten Lösung eines handelsüblichen aromatischen Polyesterpolyurethans beschichtet. Nach dem Trocknen und Abziehen des Kunstleders wurde es auf einer Druckmaschine mittels einer 48er Rasterwalze mit dem Bindemittel nach Beispiel 5 bedruckt. Die Aushärtung erfolgte unter einem Quecksilberhochdruckbrenner der Firma Hannovia (Hannovia-Strahler, 80 Watt/cm) mit einer Bandgeschwindigkeit 20 m/Min. Es wurde eine lösungsmittelfeste kratz- und reibfeste Oberfläche mit lackähnlichem Glanz erhalten. Ein ähnliches Ergebnis wird erhalten, wenn man die Mischung mittels eines 20$\mu$-Rillenrakels aufträgt und wie vorstehend beschrieben weiterverfährt.

Anwendung B

Auf ein leicht geschliffenes in üblicher Weise mit 6 Gew.-% synthetischen und vegetablischen Gerbstoffen nachgegerbtes Chromrindleder wurde eine übliche, rot eingefärbte Grundierung aus einem weichen Polyacrylat-Binder (ca. 25 Shore A), Albumin und einem mittelharten Butadien-Acrylnitrilbinder (ca. 40 Shore A) aufgespritzt, getrocknet, gebügelt, geprägt und dann die in Beispiel 4 genannte mit Essigsäureäthylester 1 : 1 verdünnte UV-Licht-härtbare Mischung gleichmäßig aufgespritzt. Nach dem Aushärten (Polymerisieren) mittels eines Hanovia-Strahlers wurde eine glänzende, reibund lösungsmittelfeste Appretur erhalten.

Beispiel 5

Es wird ein Polythioäther durch Selbstkondensation von Thiodiglykol gemäß deutscher Patentschrift 1 039 232 mit einer OH-Zahl von 350 hergestellt.

Es werden analog der Vorschrift von Beispiel 1 111 g (0,5 Mol) Isophorondiisocyanat mit 46,4 g (0,4 Mol) Hydroxyäthylacrylat, 16 g des nach der deutschen Patentschrift 1 039 232 hergestellten Polythioäthers mit einer OH-Zahl von 350, sowie 84 g eines oxäthylierten Trimethylolpropans mit einer OH-Zahl von 400, (MG 420) eingesetzt. Es resultierte ein farbloses niedrig viskoses Harz.

100 g des Harzes nach Bsp. 6 werden mit 3 g Benzophenon und 2,5 g Triäthanolamin vermischt. Es wurde auf einer speziell vorbehandelten Polyesterfolie ein 500$\mu$ dicker Film gegossen. Nach Abdecken des nassen Films mit einer sehr dünnen Kunststoff-folie wurde durch ein Halbtonnegativ 90 Sekunden mit einer Leuchtstoffröhre vom Typ TL-Ak (Firma Philips) belichtet. Nach Beendigung der Belichtung wurden die unbelichteten Stellen mit Äthylacetat abgewaschen und das entstandene Relief 10 Sekunden unter einem HTQ-7 Hochdruckstrahler nachbelichtet. Es entstand ein Relief mit einem scharfen Bild.

**Patentansprüche**

1. Strahlenhärtbares Bindemittel bestehend aus einem Umsetzungsprodukt aus

A 1 Grammäquivalent NCO eines Polyisocyanats mit 2—3 Isocyanatgruppen pro Molekül;

B) 0—0,7 Grammäquivalenten OH eines Polyols mit mind. 2 OH-Gruppen pro Molekül, frei von organisch gebundenem Schwefel, mit OH-Zahlen von 50—1830 mg KOH/g Substanz;

C) 0,01—0,7 Grammäquivalenten OH eines Hydroxyalkylacrylats mit 2—6 C-Atomen in der Alkylgruppe,

gegebenenfalls in Mischung mit anderen copolymerisierbaren Monomeren, dadurch gekennzeichnet, daß das Umsetzungsprodukte zusätzlich

D) 0,01—0,3 Grammäquivalente OH eines Thio- oder Dithio- bzw. Thio- und Dithiogruppen enthaltenden Polyols mit mind. 2 OH-Gruppen pro Molekül mit OH-Zahlen von 50—920 mg KOH/g Substanz

eingebaut enthält, die Summe der OH-Grammäquivalente B bis D 1—1,2 ist und der Gehalt an organisch gebundenem Schwefel, herrührend aus den Thio- und Dithiogruppen, 0,01—10 Gew.-%, bezogen auf Bindemittel, beträgt.

2. Strahlenhärtbares Bindemittel gemäß Anspruch 1, dadurch gekennzeichnet, daß Komponente B ein aliphatisches, gesättigtes, 2- bis 6- wertiges Polyol mit einer OH-Zahl von 100 bis 1060 mg KOH/g Substanz ist oder das vorgenannte Polyol darstellt, dessen aliphatische Kette eine oder mehrere, gleiche oder verschiedene Gruppen der Reihe Phenylen, Cyclohexylen, Oxy (—O—), Carboxylate,

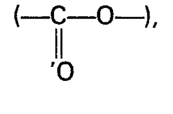

Ureylen

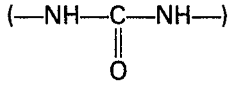

und Oxycarbonylamino

$$(-O-\underset{\underset{O}{\|}}{C}-NH-)$$

enthält oder Mischungen der Polyole und Komponente D ein aliphatisches, gesättigtes 2- bis 4-wertiges Polyol mit einer OH-Zahl von 50 bis 920 mg KOH/g Substanz und mit einer oder mehreren Thiogruppen in der aliphatischen Kette bedeutet oder das vorgenannte Polyol, das in der aliphatischen Kette zusätzlich eine oder mehrere, gleiche oder verschiedene Gruppen der Reihe Phenylen, Cyclohexylen, Oxy, Carboxylato, Ureylen und Oxycarbonylamino enthält.

**Revendications**

1. Liant durcissable par radiation, constitué par un produit de réaction:

A) de 1 équivalent-gramme de NCO d'un polyisocyanate ayant 2 à 3 groupes isocyanate par molécule;

B) de 0—0,7 équivalent-gramme de OH d'un polyol ayant au moins deux groupes OH par molécule, exempt de soufre en liaison organique, avec des indices d'hydroxyle de 50 à 1830 mg de KOH/g de substance;

C) de 0,01—0,7 équivalent-gramme de OH d'un acrylate d'hydroxyalkyle ayant 2 à 6 atomes de carbone dans le groupe alkyle,

éventuellement en mélange avec d'autres monomères copolymérisables, caractérisé en ce que le produit de réaction renferme en outre

D) 0,01—0,3 équivalent-gramme de OH d'un polyol portant des groupes thio ou dithio ou des groupes thio et dithio, avec au moins deux groupes OH par molécule, d'indices d'hydroxyle de 50 à 920 mg de KOH/g de substance,

la somme des équivalents-grammes de OH de B à D étant égale à 1—1,2 et la teneur en soufre en liaison organique, provenant des groupes thio et dithio, s'élevant à 0,01—10% en poids par rapport au liant.

2. Liant durcissable par radiation suivant la revendication 1, caractérisé en ce que le composant B est un polyol aliphatique saturé bivalent à hexavalent ayant un indice d'hydroxyle de 100 à 1060 mg de KOH/g de substance ou représente le polyol précité dont la chaîne aliphatique comprend un ou plusieurs groupes égaux ou différents de la série phénylène, cyclohexylène, oxy (—O—), carboxylato,

$$(-\underset{\underset{O}{\|}}{C}-O-),$$

uréylène

$$(-NH-\underset{\underset{O}{\|}}{C}-NH-)$$

et oxycarbonylamino

$$(-O-\underset{\underset{O}{\|}}{C}-NH-)$$

ou des mélanges des polyols, et le composant D est un polyol aliphatique saturé bivalent à tétravalent ayant un indice d'hydroxyle de 50 à 920 mg de KOH/g de substance et portant un ou plusieurs groupes thio dans la chaîne aliphatique ou le polyol précité, qui renferme en outre dans la chaîne aliphatique un ou plusieurs groupes égaux ou différents de la série phénylène, cyclohexylène, oxy, carboxylato, uréylène et oxycarbonylamino.

**Claims**

1. A radiation-hardenable binder comprising a reaction product of

A) 1 gramme equivalent of NCO of a polyisocyanate containing 2 to 3 isocyanate groups per molecule,

B) 0 to 0.7 gramme equivalents of OH of a polyol containing at least 2 OH-groups per molecule, free from organically combined sulphur, with OH numbers of from 50 to 1830 mg KOH/g of substance;

C) 0.01 to 0.7 gramme equivalents of OH of a hydroxyalkyl acrylate containing 2 to 6 carbon atoms in the alkyl group,

optionally in admixture with other copolymerizable monomers, characterised in that the reaction product has additionally incorporated therein:

D) 0.01 to 0.3 gramme equivalents of OH of a polyol containing thio or dithio, or thio and dithio groups and having at least 2 OH groups per molecule with OH numbers of from 50 to 920 mg KOH/g of substance;

the sum of the OH gramme equivalents B to D is from 1 to 1.2 and the content of organically combined sulphur derived from the thio and dithio groups is from 0.01 to 10% by weight, based on the binder.

2. A radiation-hardenable binder according to Claim 1, characterised in that component B is an aliphatic saturated 2- to 6-hydric polyol having an OH number of from 100 to 1060 mg KOh/g of substance, or is the above-mentioned polyol whose aliphatic chain contains one or more identical or different groups of the phenylene, cyclohexylene, oxy (—O—), carboxylato,

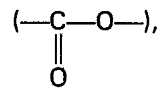

ureylene

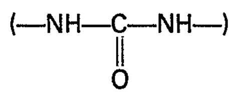

and oxycarbonyl amino

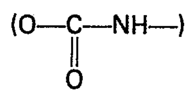

series, or mixtures of the polyols, and component D denotes an aliphatic saturated 2- to 4-hydric polyol having an OH number of from 50 to 920 mg KOH/g of substance and having one or more thio groups in the aliphatic chain, or the above-mentioned polyol which additionally contains in the aliphatic chain one or more identical or different groups of the phenylene, cyclohexylene, oxy, carboxylato, ureylene and oxycarbonyl amino series.